# EUROPEAN PATENT SPECIFICATION

(11) **EP 1 541 654 B1**
(45) Date of publication and mention of the grant of the patent: **29.02.2012**
(21) Application number: 02765410.2
(22) Date of filing: 04.09.2002
(51) Int. Cl.: C09J 9/02, C09J 11/04, H01B 1/22

(54) **CONDUCTIVE ADHESIVE AND CIRCUIT COMPRISING IT**
LEITFÄHIGER KLEBSTOFF UND IHN ENTHALTENDER SCHALTKREIS
ADHESIF CONDUCTEUR ET CIRCUIT L'UTILISANT

(43) Date of publication of application: 15.06.2005
(73) Proprietor: Namics Corporation, Niigata-shi, Niigata 950-3131 (JP); Suganuma, Katsuaki, Minoo-shi, Osaka 562-0022 (JP)
(72) Inventor: KOMAGATA, Michinori,c/o NAMICS CORPORATION, Niigata-shi, Niigata 950-3131 (JP); SHIRAI, Yukio,c/o NAMICS CORPORATION, Niigata-shi, Niigata 950-3131 (JP); SUZUKI, Kenichi,c/o NAMICS CORPORATION, Niigata-shi, Niigata 950-3131 (JP); SUGANUMA, Katsuaki, Minoo-shi, Osaka 562-0022 (JP)
(74) Representative: Hayes, Adrian Chetwynd
(86) International application number: PCT/JP2002/008969
(87) International publication number: WO 2004/022663

(56) References cited:
- EP-A2- 0 710 990
- JP-A- 3 217 476
- JP-A- 5 081 923
- JP-A- 10 279 903
- JP-A- 2000 309 773
- JP-A- 2001 200 225
- JP-A- 2001 294 844
- JP-A- 2002 265 920
- US-A- 5 395 876
- US-A1- 2008 272 344
- US-A1- 2010 221 545
- DATABASE WPI Week 199145 Derwent Publications Ltd., London, GB; AN 1991-328010 XP002481529 & JP 03 217476 A (FUKUDA KINZOKU HAKUFUN KOGYO KK) 25 September 1991 (1991-09-25)
- "Metal Handbook", 30 May 2000 (2000-05-30), Maruzen K.K. page 891, * table 13.4 *
- "Standard Test Method for Particle Size Distribution of Metal Powders and Related Compounds by Light Scattering", ASTM B822-10, - 2010, XP009151041,
- "Ultrafine particle", Wikipedia, the free encyclopedia , 13 August 2011 (2011-08-13), Retrieved from the Internet: URL:http://en.wikipedia.org/wiki/Ultrafine _particle [retrieved on 2011-08-19]
- BOWEN P: "Particle Size Distribution Measurement from Millimeters to Nanometers and from Rods to Platelets", JOURNAL OF DISPERSION SCIENCE AND TECHNOLOGY, TAYLOR AND FRANCIS GROUP, NEW YORK, NY, US, vol. 23, no. 5, 1 January 2002 (2002-01-01), pages 631-662, XP009102859, ISSN: 0193-2691, DOI: 10.1081/DIS-120015368

## Description

### Field of the invention

The present invention relates to a conductive adhesive, more specifically to a conductive adhesive having excellent electrical conductivity and capable of bonding a semiconductor element, chip parts or discrete parts to a printed wiring board without occurrence of migration. Further, the present invention relates to a circuit prepared by bonding a semiconductor element or the like using such a conductive adhesive.

### Background of the invention

As one of semiconductor mounting techniques, there is a technique of bonding with a flip chip method. In this method, using a semiconductor element with bumps formed by solder plating, bonding of the semiconductor element is carried out by means of a solder. Further, bonding with a conductive adhesive prepared by using a powder of a noble metal such as silver or the like, and electronic parts bonding with an anisotropic conductive film by the use of a powder prepared by plating resin balls with gold or the like have been attempted.

On the other hand, in formation of a circuit using a printed wiring board, a solder is also used for bonding chip parts or discrete parts. In place of the solder, a conductive adhesive is also used for mounting these parts. When silver is used as conductive particles for the adhesive, a conductive layer having excellent conductivity is obtained, but migration sometimes occurs when a voltage is applied thereon. (refer to IEEE Transaction on Components, Packaging and Manufacturing Technology, Part B, Vol. 17, No.1, p.83).

Further, in applying tin plating or the like, bonding strength lowers due to influence of high temperatures.

At present, a lead-tin alloy solder is used for electronic part bonding. When solders in discarded electronic devices are dissolved by acidic rain and dissolved in groundwater, there arises a problem in public health in the place where groundwater is used for drinking water. On this account, there is a tendency of using a solder having a higher melting point such as tin-silver type and tin-zinc type ones. However, in the method of using the solder, there is occasionally the case of using a cleaning agent and the use thereof is unfavorable in working atmosphere and safety.

Although nickel powder and nickel alloy powder are conductive particles, which induce no migration, a conductive layer formed using the powders is not satisfactory because it has high specific resistance and when it is exposed to high temperatures, the specific resistance thereof further becomes higher.

Japanese Provisional Patent Publication No. 157613/1997 discloses a method that a conductive adhesive capable of preparing a conductive layer which induces no migration and has stable conductivity even if exposed at high temperatures can be prepared by the combined use of an epoxy resin containing a reactive diluent and conductive particles prepared by surface-treating metal particles having surfaces composed of nickel and/or nickel-boron alloy with a mixture of polyoxyalkylene phosphoric acid ester derivative and polyoxyalkylene alkyl(or alkenyl)amine or derivatives thereof. However, as a recent tendency, the advent of a conductive adhesive having properties that the conductivity is enhanced and the specific resistance is slightly increased even if it is processed under a temperature condition such that it bonds to a solder at high temperatures, is demanded.

Japanese Provisional Patent Publication No. 80647/1999 or Material stage, Vol.1, No.7, p.51 2001 discloses the fact that silver fine particles are joined when heated at 200°C and development thereof to conductive adhesives. The resulting conductive adhesive comprises ultra finely powdery silver as a main ingredient so that the desired film thickness cannot be obtained and further migration occurs.

JP3217476 discloses an electroconductive elastic adhesive containing ground silver foil.

JP5081923 discloses an electric conductive adhesive agent including silver powder.

JP10279903 discloses an electroconductive adhesive comprising a metal selected from Sn, Zn, In, Bi, Pb, Cd and Sb, and a metal selected from Cu, Ni, Au, Ag, Al, Pd and Pt.

JP2000309773 discloses a conductive adhesive and a bonding method of using the same.

JP2001200225 discloses an electroconductive resin composition.

JP2001294844 discloses a conductive adhesive containing tin.

In the light of the foregoing, it is an object of the present invention to provide a conductive adhesive, which does not induce migration, has high conductivity and can be used in place of a solder, and it is a further object of the invention also to provide a circuit prepared by using the conductive adhesive.

The present inventors have earnestly studied in order to attain the objects, and found that the metal composition of a conductive adhesive comprises silver and tin in a specific composition range and thereby the object can be attained, and particularly even if tin and silver powder are simultaneously used in the above silver-tin composition range, migration is not unexpectedly induced, the metals are mutually molten by the combined use of fine particulate metal powders and are connected each other. Thus, the present invention is accomplished.

### SUMMARY OF THE INVENTION

According to a first aspect there is provided a conductive adhesive comprising conductive particles and a resin, wherein:
30% by weight or more of the conductive particles comprise (1) a silver-tin alloy powder; a mixed powder of silver powder and tin powder; or a mixed powder of silver-tin alloy powder, silver powder and tin powder,
the conductive particles further comprise a scaly powder having an average diameter of a flat surface, that is, an average of the major axis and minor axis, of from 2 to 20 µm;
the conductive particles further comprise (2) ultra fine particles of at least one of silver powder, tin powder, bismuth powder or indium powder, or alloy powder of two or more of these metals; and
a molar ratio of silver and tin in the metal components of the conductive adhesive is in the range of 77.5:22.5 to 20:80.

According to a second aspect there is provided a circuit comprising a semiconductor element, chip parts, discrete parts or a combination thereof, which are bonded using the conductive adhesive as defined herein.

According to a third aspect there is provided a circuit prepared using said conductive adhesive as defined herein, wherein the composition of the conductive adhesive is alloyed with metals of a semiconductor element, chip parts, a terminal electrode of discrete parts and a land part of a substrate.

### BEST MODE FOR CARRYING OUT THE INVENTION

The silver-tin powder substantially comprising silver and tin, which is used as conductive particles in the present invention, is a characteristic component in the present invention, and does not cause migration, and imparts high conductivity to a conductive layer formed therefrom. The metal powder has a molar ratio of silver and tin of from 77.5 : 22.5 to to 20 : 80. When the molar ratio of silver is over 77.5 based on 100 of the total molar ratio of both components, migration occurs.

The silver-tin powder may be in any form as long as silver and tin atoms are present in a complex form on the surface of one powder particle. Examples of the silver-tin powder may include alloy powder, co-precipitated powder prepared from an aqueous solution of a mixed salt by a reduction co-precipitation method, and composite powder having a surface on which silver and are present, prepared by making silver powder covered with into a scaly shape by means of a stamping method. The alloy powder is preferred because homogeneous silver-tin powder can be prepared and thereby it shows stable effect. Further, mixed powder by simply mixing silver powder and tin powder can also attain the effect of the present invention.

Such silver-tin alloy powder can be prepared by, for example, a method of mixing silver and in a desired molar ratio, melting, blowing off from a nozzle into an argon atmosphere to make alloy powder and collecting powder having a particle diameter smaller than a prescribed diameter; a method of further evaporating the thus atomized powder by a plasma furnace and solidifying by cooling to prepare alloy powder; a method of alloying mixed powder with heating by arbitrary means; and the like.

The shape of the silver-tin powder used herein comprises powder of a scaly shape. Other shapes such as needle-like or branched shape or spherical are known. Further, a mixture of the above shapes may be employed.

The silver-tin powder in a spherical shape preferably has an average particle diameter of from 0.1 to 10 µm, one in a scaly shape has an average diameter on the flat surface, that is, an average of the major axis and minor axis, of from 2 to 20 µm because the system in an adhesive state of the silver-tin powder is kept stably, and it causes no clogging in printing and further a conductive layer having high conductivity can be obtained. The aspect ratio of the powder is usually from 10 to 200, preferably 20 to 50.

The silver-tin powder having such a composition is blended in an amount of 95% by weight or less, preferably 90% by weight or less, more preferably 85% by weight or less based on the conductive particles. The silver and tin are contained in an adhesive in such an amount that the metal composition ratio of silver to tin in the range of 77.5 : 22.5 to 20 : 80 so that a conductive adhesive free from occurrence of migration and capable of forming a conductive layer having a high conductivity can be obtained.

In the present invention, as conductive particles, other metal powder (and optionally carbon powder) are used together with the above-mentioned silver-tin powder. The metal powders used in combination include ultra fine particles of silver powder, tin powder, bismuth powder or indium powder, or alloy powder, co-precipitated powder and/or composite powder of two or more kinds of these metals (hereinafter referred to as "alloy powder, etc." provided that the silver-tin powder having the composition with the above-mentioned molar ratio is excluded.). Specific examples of the alloy powder, etc. may include silver-tin bismuth powder, silver-tin indium powder and silver-tin powder having a composition other than the above-mentioned molar ratio. The metal used is preferably finely particulate conductive powder having a particle diameter in the range of 5 to 60 nm, preferably 8 to 20 nm.

Further, examples of the carbon powder may include carbon black, graphite and their meso-phase.

These ultra fine particulate conductive powders are blended in amounts of from 40% by weight to 2% by weight based on the metal powder having the above-mentioned composition because low connecting resistance can be obtained. When the amount of the fine particulate conductive powders is 40% by weight or more, the paste viscosity increases and thereby the printability and dispensing properties are not favorable. When the amount is 2% by weight or less, the metal junction is low and the connecting resistance increases. The ultra finely particulate conductive powder can be produced by known processes. A process by plasma or arc discharge is exemplified.

Of these metal powders, fine particulate conductive powder is particularly notable metal powder. Conventionally, it has been known that silver powder causes migration. However, surprisingly, the combined use of the above silver-tin powder and silver powder as conductive particles causes no migration and can produce a conductive adhesive capable of preparing a conductive layer of excellent conductivity. The silver powder is blended in an amount of preferably from 4 to 12% by weight based on the silver-tin powder having the above-mentioned composition because excellent conductivity can be obtained and migration is not induced.

Particularly notable examples of the other metal powder are tin powder, bismuth powder and silver-bismuth powder. By the combined use of the tin powder, bismuth powder and/or silver-bismuth powder, and the silver-tin powder having the above-mentioned composition, tin powder, silver-tin powder and bismuth are reacted at a curing temperature of the adhesive to induce metal junction so that high conductivity can be obtained. Such tin powder, bismuth powder or silver-bismuth powder is preferably blended in an amount in the range of 0.1 to 20% by weight based on the silver-tin powder having the above-mentioned composition.

The conductive particles contained in the conductive adhesive is preferably in an amount of from 60 to 98% by weight, more preferably 70 to 95% by weight based on the total amount of the conductive particles and the resin from the stand points of printability and conductivity of the conductive layer prepared by curing.

The conductive adhesive of the present invention contains the resin, which acts as a binder, in addition to the above conductive particles. The resin may be a thermoplastic resin or thermosetting resin. Examples of the thermoplastic resin may include acrylic resin, ethyl cellulose, polyester, polysulfone, phenoxy resin, polyimide etc. Examples of the thermosetting resin preferably include amino resins such as urea resin, melamine resin or guanamine resin; epoxy resins such as bisphenol A, bisphenol F, phenolnovolak or alicyclic type; oxetane resin; phenol resins such as resol or novolak type; silicone-modified organic resins such as silicone epoxy or silicone polyester. These resins may be used singly or in combination of two or more.

Among them, epoxy resin and resol type phenol resin are preferable, and further bisphenol A type and bisphenol F type epoxy resins are particularly preferable because even when the resin is blended in an amount of not marring the conductivity, excellent adhesion can be obtained and the heat resistance is excellent.

Using the resin in a liquid state at ordinary temperature as a resin, a vehicle can be made without using an organic solvent so that a drying step can be omitted. Such liquid resins are liquid epoxy resin, liquid phenol resin etc. Examples of the liquid epoxy resin may include bisphenol A type epoxy resin having an average molecular weight of about 400 or less; branched polyfunctional bisphenol A type epoxy resin such as p-glycidoxyphenyldimethyltolyl bisphenol A diglycidyl ether, etc; bisphenol F type epoxy resin; phenol novolak type epoxy resin having an average molecular weight of about 570 or less; alicyclic epoxy resins comprising, as a constitutional ingredient, at least one of vinyl(3,4-cyclohexene)-dioxide, (3,4-epoxycyclohexyl)methyl 3,4-epoxycyclohexylcarboxylate, bis(3,4-epoxy-6-methylcyclohexylmethyl)adipate and 2-(3,4-epoxycyclohexyl)5,1-spiro(3,4-epoxycyclohexyl)-m-dioxane; glycidyl ester type epoxy resins comprising, as a constitutional ingredient, at least one of glycidyl hexahydrophthalate, diglycidyl 3-methylhexahydrophthalate and diglycidyl hexahydroterephthalate; glycidyl amine type epoxy resins comprising, as a constitutional ingredient, at least one of diglycidyl aniline, glycidyl toluidine, triglycidyl-p-aminophenol, tetraglycidyl-m-xylylene diamine and tetraglycidyl bis(aminomethyl)cyclohexane; and hydantoin type epoxy resin comprising, as a constitutional ingredient, 1,3-diglycidyl-5-methyl-5-ethylhydantoin.

Further, a resin, which is compatible with the liquid resin, is a solid or has a super-high viscosity at ordinary temperature, may be used in blending with the liquid resin within the range that the mixture has fluidity, and examples of the resin may include epoxy resins such as high molecular weight bisphenol A type epoxy resin, diglycidyl biphenyl, novolak epoxy resin, tetrabromo bisphenol A type epoxy resin; and novolak phenol resin.

In the case of the epoxy resin, as a curing mechanism, a self-curing type resin, a curing agent or a curing accelerator such as amines, imidazoles, acid anhydride or onium salt may be used, and an amino resin or phenol resin may be also used as a curing agent for the epoxy resin.

The typical epoxy resin used in the invention is cured by the phenol resin. As the phenol resin, a phenol resin initial condensate, which is generally used as a curing agent for the epoxy resin, may be used, and a resol type one or novolak one may be used. Moreover, in order to relax the stress in curing and to obtain excellent heat cycle resistance, 50% by weight or more of the phenol resin preferably comprises an alkyl resol type or alkyl novolak type phenol resin. Also, in the case of the alkyl resol type phenol resin, it preferably has an average molecular weight of 2,000 or more in order to obtain excellent printability. In these alkyl resol type or alkyl novolak type phenol resins, as the alkyl group, those having 1 to 18 carbon atoms may be used and those having 2 to 10 carbon atoms such as ethyl, propyl, butyl, pentyl, hexyl, octyl, nonyl and decyl group are preferred.

The amount of the phenol resin used as a curing agent for the epoxy resin differs according to the kinds of the epoxy resin and the phenol resin. In order to obtain excellent stability of the specific resistance at a high temperature after curing, the weight ratio of the epoxy resin to the phenol resin is preferably in the range of 4 : 1 to 1 : 4, more preferably 4 : 1 to 1 : 1.

The amount of the resin blended in the conductive adhesive is preferably from 2 to 40% by weight, more preferably 5 to 30% by weight based on the total of the resin and the conductive particles from the standpoint of printability, and conductivity of the resulting conductive layer prepared by curing.

The conductive paste of the present invention can be adjusted by selecting the kinds of the conductive particles and the resin, and by using a diluent depending on necessity, to have a viscosity proper for the method of printing or applying on elements or substrates. For example, in the case of using the conductive paste for screen printing, the conductive paste has an apparent viscosity at ordinary temperature of preferably from 10 to 500 Pa·s, more preferably 15 to 300 Pa·s. As a diluent, an organic solvent can be used, and particularly, in the case that the resin is an epoxy resin, a reactive diluent can be used.

The organic solvent is selected according to the kind of the resin. Examples of the organic solvent may include aromatic hydrocarbons such as toluene, xylene, mesitylene and tetralin; ethers such as tetrahydrofuran; ketones such as methyl ethyl ketone, methyl isobutyl ketone, cyclohexanone and isophorone; lactones such as 2-pyrrolidone and 1-methyl-2-pyrrolidone; ether alcohols such as ethylene glycol monomethyl ether, ethylene glycol monoethyl ether, ethylene glycol monobutyl ether, diethylene glycol monomethyl ether, diethylene glycol monoethyl ether, diethylene glycol monobutyl ether and propylene glycol derivatives corresponding to these ethylene glycol monoalkyl ethers; esters such as acetic acid esters corresponding to these ether alcohols; and diesters such as methyl ester and ethyl ester of dicarboxylic acid such as malonic acid and succinic acid, etc. The amount of the organic solvent used is arbitrarily selected in accordance with the kinds of the conductive particles and the resin used and the amount ratio thereof, and also the method of printing or applying the conductive paste.

In the case that the conductive adhesive of the present invention needs to have proper fluidity and it is necessary to prevent from decrease of the thickness of the conductive adhesive or deterioration of working atmosphere due to volatilization of the solvent in order to form any patterns on the conductive adhesive by printing or applying and to fill the conductive adhesive into fine parts, a reactive diluent is preferably used as part or all of the diluent. Examples of the reactive diluent may include diglycidyl compounds such as polyethylene glycol diglycidyl ether, poly(2-hydroxypropylene)glycol diglycidyl ether, polypropylene glycol diglycidyl ether, butanediol diglycidyl ether, neopentyl glycol diglycidyl ether, diglycidyl aniline, 1,4-cyclohexanedimethanol diglycidyl ether and 1,3-bis(3-glycidoxypropyl)-1,1,3,3-tetramethyldisiloxane; and triglycidyl compounds such as trimethylolpropane triglycidyl ether and glycerin triglycidyl ether. The reactive diluent may be used, if necessary, in combination with monoglycidyl ether type reactive diluents such as n-butylglycidyl ether, and allylglycidyl ether, or monoglycidyl ester type reactive diluents such as glycidyl acrylate or glycidyl methacrylate. When, as a diluent, the organic solvent is not used and the reactive diluents are only used, these can be incorporated into the conductive layer by polymerizing and curing them in appropriate conditions in place of removal of the solvent.

In addition to the above agents, to the conductive adhesive of the present invention, a dispersing aid may be used according to necessity. Examples of the dispersing aid may include aluminum chelating compounds such as diisopropoxy(ethylacetoacetate)aluminum; titanates such as isopropyltriisostearoyl titanate and the like; aliphatic polycarboxylates; unsaturated aliphatic acid amine salts; surfactants such as sorbitan monooleate and the like, or polymer compounds such as polyester amine salt and polyamide. Further, the conductive adhesive may be blended with an inorganic and organic pigment, silane coupling agent, leveling agent, thixotropic agent and anti-forming agent.

The conductive adhesive of the present invention can be prepared by uniformly mixing the compounding components by mixing means such as an auto mortar, a propeller mixer, a kneader, a roll, a pot mill, etc. The preparation temperature is not particularly limited. For example, the conductive adhesive can be prepared at ordinary temperature.

The conductive adhesive of the present invention can be printed or applied on a substrate by an arbitrary method such as screen printing, gravure printing, dispense etc. When the organic solvent is used, the solvent is removed by vaporization at ordinary temperature or with heating after printing or application. In the case that the conductive adhesive is blended without a diluent or with only the reactive diluent as a diluent, it is not necessary to conduct the above step of removing the solvent. Then, the resin is cured with heating according to the kinds of the resin, the curing agent or the curing catalyst, usually at a temperature of from 70 to 250°C, for example, in the case of the epoxy resin wherein the phenol resin is used as a curing agent, the mixture is heated and cured at a temperature of from 150 to 200°C for 2 to 30 min and thereby a conductive circuit can be formed on an aimed part of the surface of a substrate.

In this manner, using the conductive adhesive of the present invention, a circuit bonded with a semiconductor element, chip parts and one or two or more discrete parts can be formed on the surface of the substrate.

Using the conductive adhesive of the present invention, tin plated, solder plated, palladium plated or silver-palladium terminal electrode chip parts, tin plated, solder plated or palladium plated semiconductors, and a copper-clad substrate, a substrate prepared by subjecting nickel or gold plating on copper or a ceramic substrate prepared by printing a silver, copper or silver-palladium paste on a ceramic substrate and by calcining them, are bonded with heating. In this bonding, the conductive particles having a particle diameter of from 5 to 100 nm and scaly conductive powder are welded and then bonded. In this bonding, silver is welded with tin to generate a silver-tin alloy. In order to lower the welding temperature, bismuth, indium and alloy powder containing these metals can be used simultaneously. The bonded adhesive contains a silver-tin alloy and does not induce migration.

### EXAMPLE

The present invention is described in more detail with reference to Reference Examples, Examples and Comparative Examples in below. The present invention should not be limited by these examples. In these examples, the unit "part" means "part by weight".

### Reference Example 1 - Preparation of silver-tin alloy powder

A mixed powder, which was prepared by mixing silver powder and tin powder in the molar ratio as shown in Table 1, was molten in a melting device provided with a nozzle and injected from the nozzle into an argon atmosphere at a temperature lower than the melting point of the alloy to obtain fine powder. The fine powder was classified to prepare a spherical silver-tin alloy powder having an average particle diameter as shown in Table 1.

**Table 1**

| No. | Molar ratio | | Average particle diameter (µm) |
|---|---|---|---|
| | Ag | Sn | |
| A-1 | 77.5 | 22.5 | 14 |
| A-2 | 75.0 | 25.0 | 15 |
| A-3 | 72.5 | 27.5 | 13 |
| A-4 | 67.5 | 32.5 | 12 |

Besides the above silver-tin alloy powder, the following metal powders were used.
Silver powder in a flake shape, average particle diameter of 10 µm;
Bismuth powder in a spherical shape, average particle diameter of 15 µm;
Silver-bismuth powder, alloy powder having a molar ratio of Ag to Bi of 5 : 1, in a spherical shape, average particle diameter of 15 µm;
Silver-indium powder, alloy powder having a molar ratio of Ag to In of 5 : 1 in a spherical shape, average particle diameter of 20 µm;
Tin powder in a spherical shape, average particle diameter of 15 µm.

### Reference Examples 1 to 8 (not in accordance with the present invention) and Comparative Example 1

In each example, using a triple roll mill, conductive particles as shown in Table 2, a bisphenol A type epoxy resin having an average molecular weight of 900 and a resol type alkyl phenol resin were blended and mixed homogeneously, and thereafter 2-ethyl-4-methylimidazole was added to the homogeneous mixture and further mixed. The mixture was transferred to a kneader. While mixing the mixture, diethylene glycol monobutyl ether was added to the mixture so that the system had an apparent viscosity at 25°C of 150 Pa·s. Then, mixing of the mixture was continued and thereby a conductive adhesive was prepared. The total amount of the conductive particles used was 85 parts and the amount of the resin used was 15 parts in each Example. In the adhesive of Comparative Example 1, a silver powder was only used as conductive particles.

### (1) Preparation of circuit specimen

The conductive adhesive prepared as described above was stencil-printed on the copper surface of a copper-clad glass-epoxy circuit substrate using a 75 µm thick metal mask. To the substrate, a tin plated chip resistor having a 2012 size was bonded with pressure and the adhesive was cured by heating at 150°C for 30 minutes and thereby the chip resistor was connected to the circuit substrate to prepare a circuit specimen.

### (2) Measurement of connecting resistance

The connecting resistance of the circuit specimen was measured.

### (3) Measurement of adhesion strength

The adhered part of the circuit specimen was pricked from the side using a push-pull gauge (Model PGD type II, manufactured by Marubishi Kagaku Kikai Seisakusho) and the force required to peel was measured by measuring the numerical value and it was taken as adhesion strength (initial value).

The same circuit specimen was subjected to a heat cycle test such that one cycle comprising allowing the specimen to stand
at 150°C for 30 minutes,
at 85°C at 85%RH for 30 minutes and
at -40°C for 30 minutes,
was repeated 1000 cycles and thereafter the adhesion strength was measured in the same manner as described above.

### (4) Migration test

The adhesive composition prepared as described above was screen printed on a ceramic substrate and cured by heating at 150°C for 30 minutes to prepare a counter electrode having a conductor spacing of 2 mm. A 10 V voltage was applied on between the electrodes, one drop of deionized water was dropped between the electrodes and a time that 100 mA of electric current was flown was taken as a migration time.

The results are collectively shown in Table 2.

**Table 2**

| | Reference Examples | | | | | | | | Comp. example |
|---|---|---|---|---|---|---|---|---|---|
| | 1 | 2 | 3 | 4 | 5 | 6 | 7 | 8 | 1 |
| Composition (part) | | | | | | | | | |
| Conductive particles | | | | | | | | | |
| A-1 | 85 | | | | | | | | |
| A-2 | | 85 | | | | | | | |
| A-3 | | | 85 | | 80 | 80 | 80 | 80 | |
| A-4 | | | | 80 | | | | | |
| Silver powder | | | | | | | 2.5 | 5 | 85 |
| Bismuth powder | | | | 5 | | | 2.5 | | |
| Silver-bismuth powder | | | | | 5 | | | | |
| Silver-indium powder | | | | | | 5 | | | |
| Tin powder | | | | | | | | | |
| Resin | | | | | | | | | |
| Epoxy resin | 8 | 8 | 8 | 8 | 8 | 8 | 8 | 8 | 8 |
| Phenol resin | 7 | 7 | 7 | 7 | 7 | 7 | 7 | 7 | 7 |
| 2-Ethyl-4-methyl-imidazole | 0.5 | 0.5 | 0.5 | 0.5 | 0.5 | 0.5 | 0.5 | 0.5 | 0.5 |
| connecting resistance [mΩ] | 14 | 14 | 14 | 10 | 10 | 10 | 9 | 8 | 2 |
| Adhesion strength [N] | | | | | | | | | |
| Initial value | 45 | 44 | 43 | 46 | 44 | 43 | 45 | 44 | 47 |
| After heat cycle test | 40 | 44 | 42 | 25 | 41 | 40 | 36 | 41 | 7 |
| Migration time [min] | >30 | >30 | >30 | 20 | >30 | 25 | >30 | 25 | 0.1 |

As is clear from Table 2, the specimen prepared from the conductive adhesive of Comparative Example 1 induced migration markedly, and further, after the heat cycle test, the adhesion strength remarkably lowered. On the other hand, the specimen prepared from the conductive adhesive of Reference examples 1-8 not only showed excellent connecting resistance and adhesion strength but also induced migration decreasingly, and after the heat cycle test, the adhesion strength hardly lowered.

### Reference Example 2 Preparation of silver-tin alloy powder

A mixed powder, which was prepared by mixing silver powder and tin powder in such the molar ratio as shown in Table 3, was molten in a melting device provided with a nozzle and injected from the nozzle to an argon atmosphere at a temperature lower than the melting point of the alloy to prepare fine powder. The fine powder was classified to prepare a spherical silver-tin alloy powder having an average particle diameter as shown in Table 3.

### Reference Examples 3 to 6 Ultra finely particulate silver powder, Tin powder, Bismuth powder, Copper powder and Silver-tin alloy powder

In each example, an ultra fine particulate powder was prepared by passing metal powder through plasma discharging in an argon atmosphere, to vaporize it and collecting ultra fine particulate powder by means of a collecting tank. As an ally powder, the alloy powder was previously molten and injected to prepare a powder having a particle diameter of about 50 µm. This powder was plasma vaporized in an argon atmosphere.

Besides the silver-tin alloy powder, the following metal powders were used.

Spherical silver powder, flake-like silver powder and spherical tin powder, and the particle diameters of the powders are shown in Table 3.

### Reference Examples 9 to 11 and 13 to Comparative Examples 2 to 5, and inventive Example 12

In each example, using triple rolls, conductive particles as shown in Table 3, a bisphenol A type epoxy resin (average molecular weight: 380) and a resol type alkyl phenol resin (average molecular weight: 3400) were blended in a proportion such that a weight ratio of epoxy resin to phenol resin was 10 : 5 and mixed to prepare a homogeneous mixture having an average molecular weight of 900. To the mixture, 2-ethyl-4-methylimidazole was added and mixed. The mixture was transferred to a kneader. Diethylene glycol monobutyl ether was added in an amount such that the appearent viscosity of the system at 25°C was 150 Pa·s to the mixture while mixing. The mixing was continued to prepare a conductive adhesive. In any of the examples, the total amount of the conductive particles used was 85 parts by weight and the amount of the resin used was 15 parts by weight. However, in the adhesive of Comparative Example 2, silver powder was only used as conductive particles, and in the adhesive of Comparative Example 3, a part of the silver powder was replaced with fine powder having a particle diameter of 10 nm. The connecting resistance lowered but the migration was not good. In Comparative Example 4, silver-tin alloy powder was used. The silver-tin alloy powder had a large particle diameter and was free from metal fusion so that the connecting resistance was high. In Comparative Example 5, a conventional lead-tin eutectic solder was used.

### (1) Preparation of circuit specimen

Using the conductive adhesive prepared in the above, a circuit specimen was prepared in the same manner as Examples 1 to 8.

### (2) Measurement of connecting resistance

The connecting resistance of the circuit specimen was measured.

### (3) Measurement of adhesion strength

The adhesion strength was measured in the same manner as Examples 1 to 8.

### (4) Migration test

The migration time was measured in the same manner as Examples 1 to 8.

The results are collectively shown in Table 3.

**Table 3**

| | | | Reference Examples | | | Inv. | Examples (Reference) | | | | | | | Comparative examples | | | |
|---|---|---|---|---|---|---|---|---|---|---|---|---|---|---|---|---|---|
| | | | 9 | 10 | 11 | 12 | 13 | 14 | 15 | 16 | 17 | 18 | 19 | 2 | 3 | 4 | 5 |
| Resin | | | 15 | 15 | 15 | 15 | 15 | 15 | 15 | 15 | 15 | 15 | 15 | 15 | 15 | 15 | |
| Silver tin powder *1 | | 7 µm | 75 | 50 | 35 | 30 | | 50 | | 60 | 60 | 60 | 50 | | | 65 | |
| Silver powder | | 0.5 µm | | | 30 | 20 | 50 | | | | | | | 65 | 50 | | |
| Tin powder | | 7 µm | | 25 | 10 | | 20 | 25 | 70 | 15 | 15 | 15 | 25 | | | | |
| Scaly silver powder | | 15 µm | | | | 20 | | | | | | | | 25 | 25 | 20 | |
| Silver powder | | 10 nm | | 5 | 5 | | | | | | | | | | 10 | | |
| Tin powder | | 12 nm | 10 | 5 | | 15 | 15 | 5 | 10 | | | | 5 | | | | |
| Silver tin powder *2 | | 9 nm | | | | | | 5 | | 5 | 5 | 5 | | | | | |
| Copper powder | | 14 nm | | | | | | | 5 | | | | | | | | |
| Bismuth powder | | 13 nm | | | 5 | | | | | 5 | | | | | | | |
| Silver indium powder*3 | | 20 nm | | | | | | | | | 5 | | | | | | |
| Silver bismuth powder*4 | | 14 nm | | | | | | | | | | 5 | | | | | |
| Silver tin powder *2 | | 55 nm | | | | | | | | | | | 5 | | | | |
| Connecting resistance (mΩ) | | | 4 | 4 | 4 | 4 | 4 | 4 | 4 | 4 | 4 | 4 | 5 | 12 | 5 | 35 | 2 |
| Adhesion strength (N) | | | 45 | 45 | 45 | 45 | 45 | 45 | 45 | 45 | 45 | 45 | 45 | 45 | 45 | 45 | 45 |
| Migration time (min) | | | >30 | >30 | >30 | >30 | 20 | >30 | >30 | >30 | >30 | >30 | >30 | 20 | 0.1 | 1 | >30 |
| After stability test (1000 hr) | Allowing high temp. | | 45 | 45 | 45 | 40 | 25 | 40 | 40 | 35 | 40 | 40 | 40 | 5 | 5 | 30 | 10 |
| | High temp. high humidity test | | 45 | 45 | 45 | 40 | 25 | 40 | 40 | 35 | 40 | 40 | 40 | 35 | 30 | 35 | 35 |
| | Heat cycle test | | 45 | 45 | 45 | 40 | 25 | 40 | 40 | 35 | 40 | 40 | 40 | 10 | 5 | 30 | 15 |

| | | | | | | | | | | | | | | | | | |
|---|---|---|---|---|---|---|---|---|---|---|---|---|---|---|---|---|---|
| *1: Ag/Sn=75/25, *2: Ag/Sn=50/50, *3: Ag/In=80/20, *4: Ag/Bi=50/50, Ratio is a molar ratio | | | | | | | | | | | | | | | | | |

As is clears from Table 3, the specimen prepared from the conductive adhesive in each of Comparative Example 2 and 3 had migration remarkably and after the heat cycle test, the adhesion strength remarkably lowered. On the other hand, the specimen prepared from the conductive adhesive of the present invention not only showed excellent connecting resistance and adhesion strength but also induced migration to a smaller extent, and further after the heat cycle test, the adhesion strength hardly lowered.

By the observation of the adhesive layer prepared after curing with heat, silver-tin crystals were observed except for Example 15. It is considered that the stable crystals were generated to thereby prevent the adhesive layer from occurrence of migration.

### Industrial applicability

The conductive adhesion of the present invention is printed or applied on a substrate and cured to form a conductive layer having the properties that it does not induce migration, has high conductivity, can be used in place of a solder, or even if it is exposed to high temperatures, for example, it is contacted with a molten solder having a high melting point, the specific resistance is slightly changed, and particularly the specific resistance is not increased by corrosion caused with the presence of moisture at high temperatures.

Utilizing such advantages, the conductive adhesive of the present invention is very useful for connecting or mounting semiconductors or electric parts and using the conductive adhesive, the formation of micro electric circuits can be carried out to advantage.

## Claims

1. A conductive adhesive comprising conductive particles and a resin, wherein:
30% by weight or more of the conductive particles comprise (1) a silver-tin alloy powder; a mixed powder of silver powder and tin powder or a mixed powder of silver-tin alloy powder, silver powder and tin powder the conductive particles further comprise a scaly powder having an average diameter of
a flat surface, that is, an average of the major axis and minor axis, of from 2 to 20 µm;
the conductive particles further comprise (2) ultra fine particles of at least one of silver powder, tin powder, bismuth powder or indium powder, or alloy powder of two or more of these metals; and
a molar ratio of silver and tin in the metal components of the conductive adhesive is in the range of 77.5:22.5 to 20:80.

2. The conductive adhesive according to claim 1, wherein 40% by weight or more of the conductive particles of the conductive adhesive substantially comprise silver and tin.

3. The conductive adhesive according to claim 1 or claim 2, wherein the molar ratio of silver and tin in the metal components of the conductive adhesive is in the range of 75:25 to 20:80.

4. The conductive adhesive according to any one of claims 1 to 3, wherein the molar ratio of silver and tin in the metal components of the conductive adhesive is in the range of 62.5:37.5 to 77.5:22.5.

5. The conductive adhesive according to claim 4, wherein silver powder is contained in an amount of 4 to 12% by weight based on the silver-tin powder as claimed in claim 4 as conductive particles.

6. The conductive adhesive according to claim 4, wherein bismuth powder and/or silver-bismuth powder and is/are contained in an amount of 0.1 to 20% by weight based on the silver-tin powder as claimed in claim 4 as conductive particles.

7. A circuit comprising a semiconductor element, chip parts, discrete parts or a combination thereof, which are bonded using the conductive adhesive as defined in any one of claims 1 to 6.

8. A circuit prepared using said conductive adhesive as defined in any one of claims 1 to 6, wherein the composition of the conductive adhesive is alloyed with metals of a semiconductor element, chip parts, a terminal electrode of discrete parts and a land part of a substrate.

9. A circuit according to claim 8, wherein silver-tin alloy is contained in the metals of the alloyed connection structure parts.

## Patentansprüche

1. Leitfähiger Klebstoff, umfassend leitfähige Teilchen und ein Harz, worin:
30 Gew.-% oder mehr der leitfähigen Teilchen (1) ein Silber-Zinn-Legierungspulver; ein gemischtes Pulver aus Silberpulver und Zinnpulver; oder ein gemischtes Pulver aus Silber-Zinn-Legierungspulver, Silberpulver und Zinnpulver umfassen,
die leitfähigen Teilchen weiterhin ein schuppiges Pulver mit einem mittleren Durchmesser einer flachen Oberfläche, d.h. einem Mittel aus der Hauptachse und Nebenachse, von 2 bis 20 µm umfasst;
worin die leitfähigen Teilchen weiterhin (2) ultrafeine Teilchen aus mindestens einem aus Silberpulver, Zinnpulver, Bismutpulver oder Indiumpulver, oder Legierungspulver aus zwei oder mehreren dieser Metalle umfassen; und
ein molares Verhältnis von Silber und Zinn in den Metallkomponenten des leitfähigen Klebstoffs im Bereich von 77,5:22,5 bis 20:80 ist.

2. Leitfähiger Klebstoff nach Anspruch 1, worin 40 Gew.-% oder mehr der leitfähigen Teilchen des leitfähigen Klebstoffs im wesentlichen Silber und Zinn umfassen.

3. Leitfähiger Klebstoff nach Anspruch 1 oder Anspruch 2, worin das molare Verhältnis von Silber und Zinn in den Metallkomponenten des leitfähigen Klebstoffs im Bereich von 75:25 bis 20:80 ist.

4. Leitfähiger Klebstoff nach einem der Ansprüche 1 bis 3, worin das molare Verhältnis von Silber und Zinn in den Metallkomponenten des leitfähigen Klebstoffs im Bereich von 62,5:37,5 bis 77,5:22,5 ist.

5. Leitfähiger Klebstoff nach Anspruch 4, worin das Silberpulver in einer Menge von 4 bis 12 Gew.-%, basierend auf dem Silber-Zinn-Pulver, wie in Anspruch 4 beansprucht, als leitfähige Teilchen enthalten ist.

6. Leitfähiger Klebstoff nach Anspruch 4, worin Bismutpulver und/oder Silber-Bismut-Pulver vorliegen und in einer Menge von 0,1 bis 20 Gew.%, basierend auf Silber-Zinn-Pulver, wie in Anspruch 4 beansprucht, als leitfähige Teilchen enthalten ist/sind.

7. Schaltkreis, umfassend ein Halbleiterelement, Chip-Teile, diskrete Bauteile oder eine Kombination davon, die verbunden sind unter Verwendung des leitfähigen Klebers, wie in einem der Ansprüche 1 bis 6 definiert.

8. Schaltkreis, hergestellt unter Verwendung des leitfähigen Klebers, wie in einem der Ansprüche 1 bis 6 definiert, worin die Zusammensetzung des leitfähigen Klebers mit Metallen eines Halbleiterelements, Chipteilen, einer terminalen Elektrode diskreter Bauteile und einem Anschlussteil eines Substrats legiert ist.

9. Schaltkreis nach Anspruch 8, worin Silber-Zinn-Legierung in den Metallen der legierten Verbindungsstrukturteile enthalten ist.

## Revendications

1. Adhésif conducteur comprenant des particules conductrices et une résine, dans lequel :
30 % en poids ou plus des particules conductrices comprennent (1) une poudre d'alliage argent-étain ; un mélange de poudres d'une poudre d'argent et d'une poudre d'étain ; ou un mélange de poudres d'une poudre d'alliage argent-étain, d'une poudre d'argent et d'une poudre d'étain,
les particules conductrices comprennent en outre une poudre écailleuse ayant un diamètre moyen d'une surface plate, c'est à dire, une moyenne du grand axe et du petit axe, de 2 à 20 µm ;
les particules conductrices comprennent en outre (2) des particules ultrafines d'au moins l'une parmi une poudre d'argent, une poudre d'étain, une poudre de bismuth ou une poudre d'indium, ou une poudre d'alliage de deux ou plus de ces métaux ; et
un rapport molaire d'argent et d'étain dans les composants métalliques de l'adhésif conducteur se situe dans la plage allant de 77,5:22,5 à 20:80.

2. Adhésif conducteur selon la revendication 1, dans lequel 40 % en poids ou plus des particules conductrices de l'adhésif conducteur comprennent essentiellement de l'argent et de l'étain.

3. Adhésif conducteur selon la revendication 1 ou 2, dans lequel le rapport molaire d'argent et d'étain dans les composants métalliques de l'adhésif conducteur se trouve dans la plage allant de 75:25 à 20:80.

4. Adhésif conducteur selon l'une quelconque des revendications 1 à 3, dans lequel le rapport molaire d'argent et d'étain dans les composants métalliques de l'adhésif conducteur se situe dans la plage allant de 62,5:37,5 à 77,5:22,5.

5. Adhésif conducteur selon la revendication 4, dans lequel la poudre d'argent est contenue en une quantité de 4 à 12 % en poids sur la base de la poudre d'argent-étain telle que revendiquée dans la revendication 4 en tant que particules conductrices.

6. Adhésif conducteur selon la revendication 4, dans lequel une poudre de bismuth et/ou une poudre d'argent-bismuth est/sont contenue(s) en une quantité de 0,1 à 20 % en poids sur la base de la poudre d'argent-étain telle que revendiquée dans la revendication 4 en tant que particules conductrices.

7. Circuit comprenant un élément semi-conducteur, des parties formant puce, des parties discrètes ou leur combinaison, qui sont liées en utilisant l'adhésif conducteur tel que défini dans l'une quelconque des revendications 1 à 6.

8. Circuit préparé en utilisant ledit adhésif conducteur tel que défini dans l'une quelconque des revendications 1 à 6, dans lequel la composition de l'adhésif conducteur est alliée avec des métaux d'un élément semi-conducteur, des parties formant puce, une électrode de borne des parties discrètes et une partie formant méplat d'un substrat.

9. Circuit selon la revendication 8, dans lequel un alliage argent-étain est contenu dans les métaux des parties de structure de connexion alliées.
